# EUROPEAN PATENT APPLICATION

(11) **EP 1 858 083 A2**
(43) Date of publication of application: **21.11.2007**
(21) Application number: 07101183.7
(22) Date of filing: 25.01.2007
(51) Int. Cl.: H01L 27/146

(54) **Solid-state imaging device**

(30) Priority: 15.05.2006 JP 2006135422
(71) Applicant: MATSUSHITA ELECTRIC INDUSTRIAL CO., LTD., Osaka 571-8501 (JP)
(72) Inventor: Kano, Takatoshi, Chuo-ku Osaka-shi Osaka 540-6319 (JP); Uchida, Mikiya, Chuo-ku Osaka-shi Osaka 540-6319 (JP)
(74) Representative: Grünecker, Kinkeldey, Stockmair & Schwanhäusser Anwaltssozietät

(57) **Abstract**

There are provided an easy-to-use solid-state imaging device which reduces a noise generated, and a method for fabricating such a solid-state imaging device. Among a plurality of MOS transistors comprising the solid-state imaging device (1), a polycrystalline silicon into which a P type impurity is introduced is used to form at least one of gate electrodes (108a) and (108b) of N type MOS transistors (109a) and (109b) included in a pixel (5). In this case, the introduction of the P type impurity into the gate electrode (108a) or (108b) of the N type MOS transistor (109a) or (109b), and the introduction of the P type impurity into a gate electrode (108c) of a P type MOS transistor (109c) are simultaneously performed.

## Description

### BACKGROUND OF THE INVENTION

### Field of the Invention

The present invention relates to a solid-state imaging device used in an apparatus such as a digital camera and a digital video camera.

### Description of the Background Art

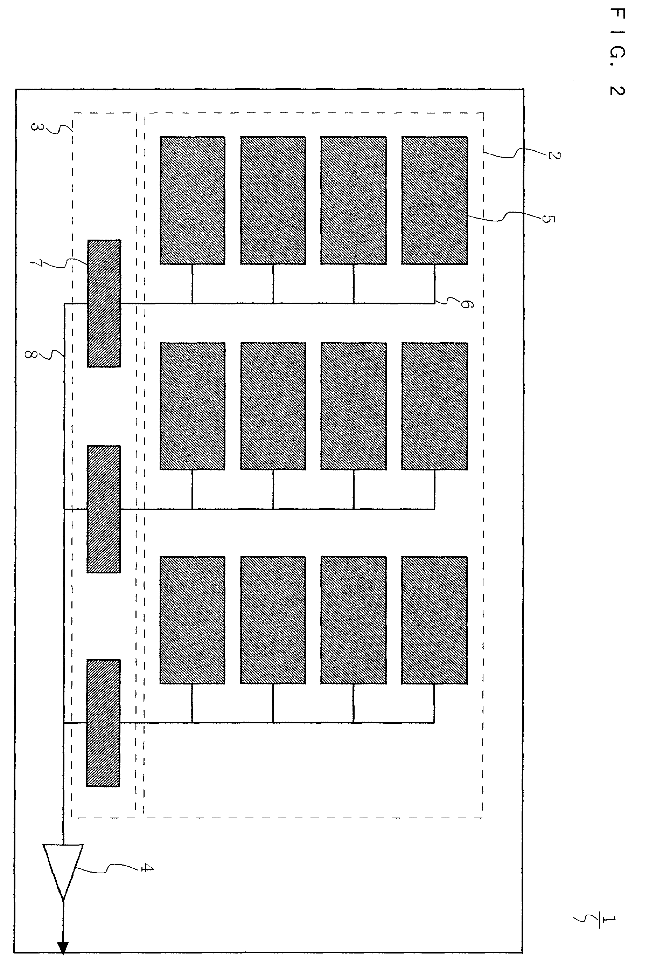

FIG. 2 is a diagram illustrating a configuration of a conventional MOS type solid-state imaging device 1. The solid-state imaging device 1 comprises a pixel region 2, a signal processing region 3, a horizontal signal line 8, and an output amplifier 4. The pixel region 2 includes a plurality of pixels 5 arranged in the row and column directions in a form of a matrix, and a vertical signal line 6 connected to each of the pixels 5 which are aligned in a same column. The signal processing region 3 includes a noise canceling circuit 7. The pixels 5 and the noise canceling circuit 7 will be described in detail later.

The each of the pixels 5 converts an incident light into a pixel signal and outputs the pixel signal. The noise canceling circuit 7 removes a noise superimposed on the pixel signal received through the vertical signal line 6, and outputs the pixel signal from which the noise has been removed to the horizontal signal line 8 . The output amplifier 4 amplifies the pixel signal received through the horizontal signal line 8, and outputs the amplified pixel signal to an exterior of the solid-state imaging device 1.

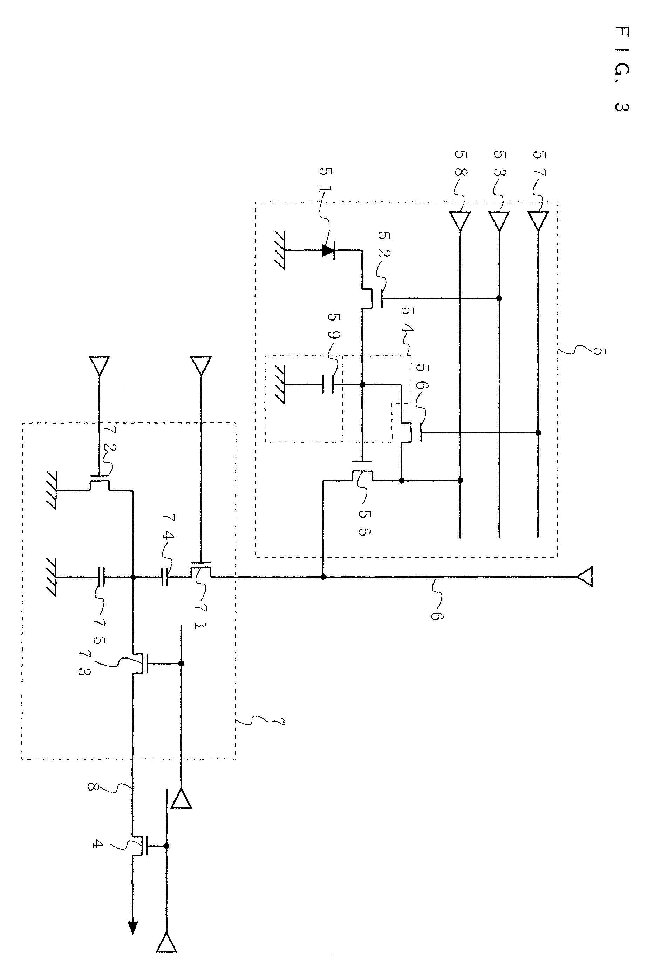

FIG. 3 is a circuit diagram of the solid-state imaging device 1 shown in FIG. 2. The pixel 5 includes a photodiode 51, a transmission transistor 52, a TRANS signal line (transmission transistor control signal line) 53, a floating diffusion 54, an amplifying transistor 55, a reset transistor 56, an RSCELL signal line (reset transistor control signal line) 57, and a VDD signal line (power resource supplying line) 58.

An electric charge accumulated, due to a photoelectric conversion, in the photodiode 51 is transmitted to the floating diffusion 54 by turning on the transmission transistor 52. The amplifying transistor 55 amplifies a pixel signal in accordance with an electric potential of the floating diffusion 54, and outputs the amplified pixel signal to the vertical signal line 6. Thereafter, an electric charge accumulated in the floating diffusion 54 is discharged by turning on the reset transistor 56, and the electric potential of the floating diffusion 54 is reset to a power source voltage.

The noise canceling circuit 7 includes a signal input transistor 71, a signal retention transistor 72, a column selection transistor 73, and capacitors 74 and 75. The signal input transistor 71 causes a pixel signal outputted from the vertical signal line 6 to input to the capacitor 74.

The noise canceling circuit 7 detects a noise component based on a pixel signal outputted from the amplifying transistor 55 when a signal electric charge is accumulated in the floating diffusion 54, and a pixel signal outputted from the amplifying transistor 55 when the electric potential of the floating diffusion 54 is reset, and then retains the detected noise component. Then, the noise canceling circuit 7 obtains a difference between the pixel signal outputted from the amplifying transistor 55 and the noise component retained by the noise canceling circuit 7, thereby removing the noise component included in the pixel signal. The pixel signal from which the noise component has been removed is outputted to the horizontal signal line 8 by turning on the column selection transistor 73.

In recent years, as the number of pixels used in a solid-state imaging device increases, a size of a transistor included in the solid-state imaging device has been reduced. As a result, there has been a problem of a flicker noise caused by an interface state existing on a surface of a semiconductor substrate immediately below a gate electrode of the transistor.

Such a flicker noise is caused when an electron flowing through a channel of a MOS transistor passes through an interface between a silicon substrate and a gate insulating film. As a method for reducing the flicker noise, an effective method using a buried channel type MOS transistor is widely known. The method for reducing the flicker noise by using such a buried channel type MOS transistor is disclosed in Japanese Laid-Open Patent Publication No. 7-122733, for example.

Note that a buried channel type transistor disclosed in Japanese Laid-Open Patent Publication No. 7-122733 is fabricated by a method for forming an implantation layer of an opposite conductivity type of a channel immediately below a gate oxide film.

In this method using the buried channel type transistor, however, the implantation layer pushes the channel into an interior of the substrate, thereby generating a depletion layer of the buried channel type MOS transistor larger than that of a surface channel type MOS transistor. Therefore, there is a problem in that a short channel effect of the buried channel type MOS transistor fabricated by the aforementioned method is larger than that of the surface channel type MOS transistor.

As described above, when comparing the buried channel type MOS transistor with the surface channel type MOS transistor, the buried channel type MOS transistor generates less flicker noise than the surface channel type MOS transistor. Therefore, an amplifying transistor is preferably the buried channel type MOS transistor.

Furthermore, as described above, in order to form the buried channel type MOS transistor, a method for changing, by ion implantation, a profile of an impurity immediately below a gate electrode of the surface channel type MOS transistor, without changing a conductivity type of the gate electrode, is well known.

However, as compared to the surface channel type MOS transistor, the buried channel type MOS transistor fabricated by the aforementioned method has an implantation layer immediately below the gate electrode, thereby causing the profile of the impurity immediately below the gate electrode to be more complicated. As a result, a subthreshold characteristic of the buried channel type MOS transistor deteriorates.

Furthermore, in the conventional solid-state imaging device, a profile of an impurity immediately below a gate electrode of the surface channel type MOS transistor differs from a profile of an impurity immediately below a gate electrode of the buried channel type MOS transistor. Accordingly, subthreshold characteristics of the above two MOS transistors differ from each other, thereby decreasing a range of voltage used for driving the solid-state imaging device.

Still furthermore, in the method for fabricating the conventional solid-state imaging device, an implantation step for forming the buried channel type MOS transistor is required. Thus, the number of fabrication steps is increased, thereby resulting in an increased fabrication cost.

### SUMMARY OF THE INVENTION

An object of the present invention is to provide an easy-to-handle and inexpensive solid-state imaging device, which has a wide range of available driving voltage and reduces a noise generated, by causing a profile of an impurity immediately below a gate electrode of a surface channel type MOS transistor to coincide with a profile of an impurity immediately below a gate electrode of a buried channel type MOS transistor.

Another object of the present invention is to provide a method for easily fabricating a solid-state imaging device in which a plurality of buried channel type MOS transistors are selectively formed in desired regions.

In order to attain the objects mentioned above, a first aspect of the present invention is directed to a solid-state imaging device comprising a pixel region in which a plurality of pixels are disposed in a form of a matrix on a semiconductor substrate, wherein each of the plurality of pixels includes: a photodiode for photoelectrically converting an incident light; and an amplifying transistor for amplifying a pixel signal outputted from the photodiode, and the amplifying transistor is a buried channel type MOS transistor.

In a second aspect based on the first aspect, each of the plurality of pixels further includes: a transmission transistor; and a reset transistor, and each of the transmission transistor and the reset transistor is a surface channel type MOS transistor.

In a third aspect based on the first aspect, the solid-state imaging device further comprises: a noise canceling circuit, disposed on the semiconductor substrate and at an exterior of the pixel region, for removing a noise component included in the pixel signal outputted from the amplifying transistor; and an output amplifier, disposed on the semiconductor substrate and at the exterior of the pixel region, for amplifying the pixel signal outputted from the noise canceling circuit, and outputting the amplified pixel signal, wherein each of transistors forming the noise canceling circuit and a transistor as the output amplifier is a surface channel type MOS transistor.

In a fourth aspect based on the second aspect, the solid-state imaging device further comprises: a noise canceling circuit, disposed on the semiconductor substrate and at an exterior of the pixel region, for removing a noise component included in the pixel signal outputted from the amplifying transistor; and an output amplifier, disposed on the semiconductor substrate and at the exterior of the pixel region, for amplifying the pixel signal outputted from the noise canceling circuit, and outputting the amplified pixel signal, wherein each of transistors forming the noise canceling circuit and a transistor as the output amplifier is the surface channel type MOS transistor.

In a fifth aspect based on the first aspect, the solid-state imaging device further comprises: a noise canceling circuit, disposed on the semiconductor substrate and at an exterior of the pixel region, for removing a noise component included in the pixel signal outputted from the amplifying transistor; and an output amplifier, disposed on the semiconductor substrate and at the exterior of the pixel region, for amplifying the pixel signal outputted from the noise canceling circuit, and outputting the amplified pixel signal, wherein at least one of transistors forming the noise canceling circuit or a transistor as the output amplifier is the buried channel type MOS transistor.

In a sixth aspect based on the second aspect, the solid-state imaging device further comprises: a noise canceling circuit, disposed on the semiconductor substrate and at an exterior of the pixel region, for removing a noise component included in the pixel signal outputted from the amplifying transistor; and an output amplifier, disposed on the semiconductor substrate and at the exterior of the pixel region, for amplifying the pixel signal outputted from the noise canceling circuit, and outputting the amplified pixel signal, wherein at least one of transistors forming the noise canceling circuit or a transistor as the output amplifier is a buried channel type MOS transistor.

In a seventh aspect based on the first aspect, the solid-state imaging device further comprises: a noise canceling circuit, disposed on the semiconductor substrate and at an exterior of the pixel region, for removing a noise component included in the pixel signal outputted from the amplifying transistor; and an output amplifier, disposed on the semiconductor substrate and at the exterior of the pixel region, for amplifying the pixel signal outputted from the noise canceling circuit, and outputting the amplified pixel signal, wherein each of N type MOS transistors included in the pixel region, the noise canceling circuit and the output amplifier is the buried channel type MOS transistor.

In an eighth aspect based on the first aspect, the amplifying transistor is an N type MOS transistor having a P type silicon film as a gate electrode.

In a ninth aspect based on the second aspect, the amplifying transistor is an N type MOS transistor having a P type silicon film as a gate electrode.

In a tenth aspect based on the third aspect, the amplifying transistor is an N type MOS transistor having a P type silicon film as a gate electrode.

In an eleventh aspect based on the fourth aspect, the amplifying transistor is an N type MOS transistor having a P type silicon film as a gate electrode.

In a twelfth aspect based on the fifth aspect, the amplifying transistor is an N type MOS transistor having a P type silicon film as a gate electrode.

In a thirteenth aspect based on the sixth aspect, the amplifying transistor is an N type MOS transistor having a P type silicon film as a gate electrode.

In a fourteenth aspect based on the seventh aspect, the amplifying transistor is an N type MOS transistor having a P type silicon film as a gate electrode.

In a fifteenth aspect based on the second aspect, each of the transmission transistor and the reset transistor is an N type MOS transistor having an N type silicon film as a gate electrode .

In sixteen aspect based on the third aspect, each of the transmission transistor and the reset transistor is an N type MOS transistor having an N type silicon film as a gate electrode.

A seventeenth aspect of the present invention is directed to a method for fabricating a solid-state imaging device comprising a P type MOS transistor and N type MOS transistors of a plurality of types on a semiconductor substrate, the method comprises: a film forming step of forming a film, on the semiconductor substrate, which is made from a material used for forming a gate electrode; a resist pattern forming step of forming a photo resist pattern on a surface of the formed film, the photo resist pattern having openings in regions where the P type MOS transistor and the N type MOS transistors of at least one of the plurality of types are formed; and an impurity implanting step of introducing a P type impurity into the film using the formed photo resist pattern as a mask.

According to the present invention, in the case where a solid-state imaging device including a P type MOS transistor is fabricated, it is possible to form the P type MOS transistor using a buried channel without increasing the number of fabrication steps. Therefore, a high-performance solid-state imaging device capable of reducing a noise generated can be provided at low cost.

Furthermore, according to a method for fabricating the solid-state imaging device of the present invention, a profile of an impurity, introduced by ion implantation, immediately below a gate electrode of a buried channel type MOS transistor will be substantially the same as a profile of an impurity, introduced by ion implantation, immediately below a gate electrode of a surface channel type MOS transistor. Therefore, a subthreshold characteristic of the buried channel type MOS transistor can be maintained so as to be substantially equal to a subthreshold characteristic of the surface channel type MOS transistor.

As a result, as compared to a solid-state imaging device including a buried channel type MOS transistor formed only by changing a profile of an impurity, introduced by ion implantation, immediately below a gate electrode, an easy-to-handle solid-state imaging device, which has a wide range of available driving voltage and reduces a noise generated, can be provided. Furthermore, the aforementioned solid-state imaging device can be fabricated by a simple method without increasing the number of the fabrication steps.

These and other objects, features, aspects and advantages of the present invention will become more apparent from the following detailed description of the present invention when taken in conjunction with the accompanying drawings.

### BRIEF DESCRIPTION OF THE DRAWINGS

FIG. 1A is a diagram illustrating a method for fabricating a solid-state imaging device according to a first embodiment of the present invention;
FIG. 1B is a diagram illustrating the method for fabricating the solid-state imaging device to be performed after FIG. 1A;
FIG. 1C is a diagram illustrating the method for fabricating the solid-state imaging device to be performed after FIG. 1B;
FIG. 1D is a diagram illustrating the method for fabricating the solid-state imaging device to be performed after FIG. 1C;
FIG. 1E is a diagram illustrating the method for fabricating the solid-state imaging device to be performed after FIG. 1D;
FIG. 2 is a diagram illustrating a configuration of the solid-state imaging device according to the present invention; and
FIG. 3 is a diagram illustrating circuits of the solid-state imaging device according to the present invention.

### DESCRIPTION OF THE PREFERRED EMBODIMENTS

### (first embodiment)

An embodiment of the present invention will be described with reference to the drawings. FIGs . 1A to 1E are cross-sectional views illustrating respective steps of a method for fabricating a solid-state imaging device according to a first embodiment of the present invention. Note that the solid-state imaging device of the present invention is similar to the conventional solid-state imaging device except for a structure of a MOS transistor formed on a semiconductor substrate. Therefore, FIGs. 2 and 3 will also be used in the present embodiment.

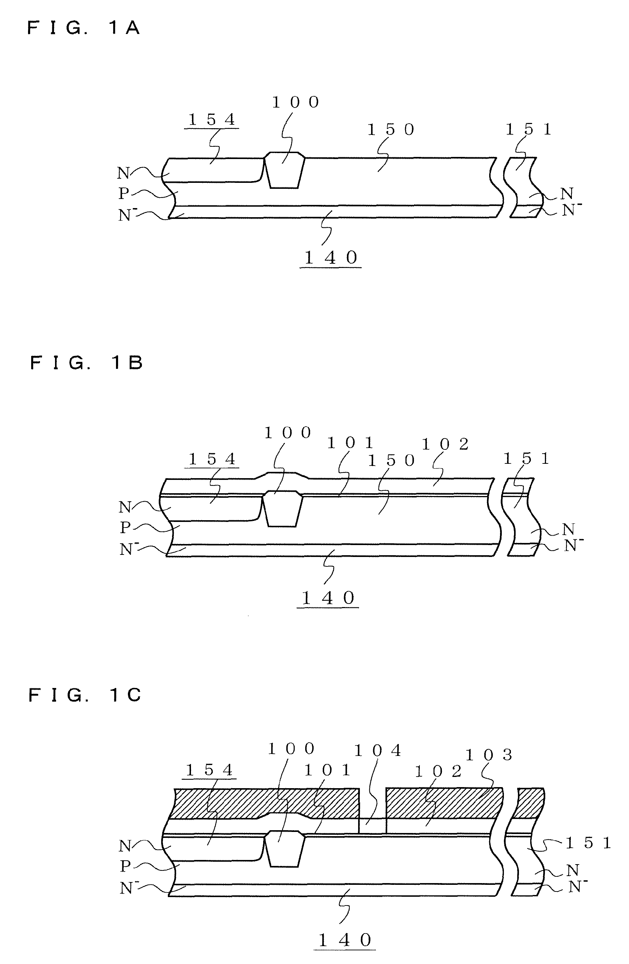

FIGs. 1A to 1E show the respective fabrication steps of the solid-state imaging device comprising an N type semiconductor substrate 140, a P type well 150, an N type well 151 (a region in which a P type MOS transistor, included in a circuit other than the pixel 5 and the noise canceling circuit 7, should be formed), and a photodiode 154, for example. Note that the pixel 5 and the noise canceling circuit 7 shown in FIG. 3 can be used as a pixel and a noise canceling circuit of the solid-state imaging device according to the present invention, respectively.

Firstly, as shown in FIG. 1A, a device isolation region 100 is formed on the semiconductor substrate 140 by STI (Shallow Trench Isolation) or LOCOS (Local Oxidation of Silicon).

Next, an impurity is introduced into the semiconductor substrate 140, thereby forming the P type well 150, the N type well 151, and the N type well 154. Then, an impurity is introduced into a surface of each of the N type well 151 and the N type well 154, thereby forming an implantation layer for adjusting a threshold voltage of a transistor.

Subsequently, as shown in FIG. 1B, an insulating film 101 is uniformly formed on a surface of the semiconductor substrate 140. Then, an amorphous silicon film or a polycrystalline silicon film 102 (hereinafter, such types of silicon films will be simply referred to as a silicon film 102), which substantially includes no impurity, is formed on a surface of the insulating film 101 so as to have a thickness of 100 to 400nm.

Then, as shown in FIG. 1C, a resist pattern 103 is formed, by a photolithography technology, on a surface of the silicon film 102, the resist pattern having an opening in a region where an N type MOS transistor, having a gate electrode into which an N type impurity is introduced, is formed, but not having an opening in a region where an N type MOS transistor, having a gate electrode into which a P type impurity is introduced, is formed.

Next, an N type impurity, such as phosphorus or arsenic, having a concentration of 1 x 10¹⁴cm⁻² to 1 x 10¹⁶cm⁻² is introduced into the silicon film 102 using the formed resist pattern 103 as a mask. Then, an anneal is performed so as to form a polycrystalline silicon region 104 into which an N type impurity is introduced.

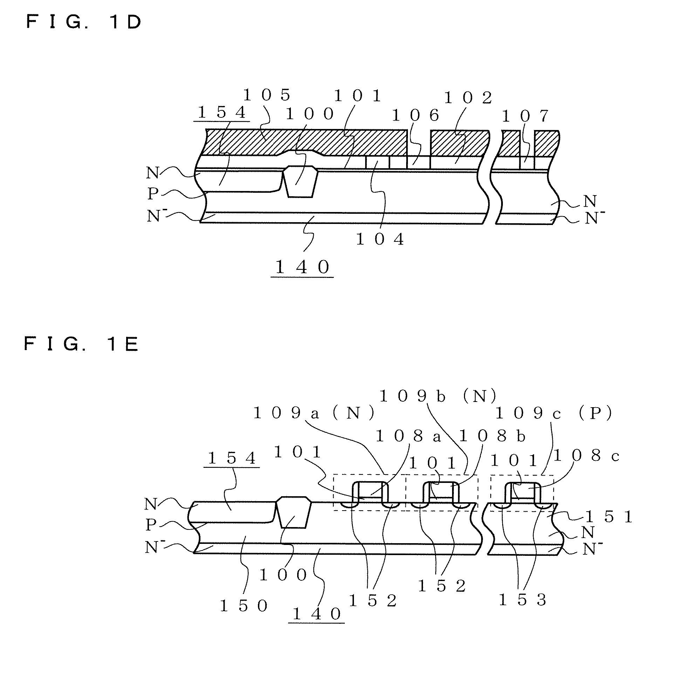

Subsequently, as shown in FIG. 1D, a resist pattern 105 is formed, by the photolithography technology, on the surface of the silicon film 102, the resist pattern having openings in regions where a P type MOS transistor and an N type MOS transistor, each having a gate electrode into which a P type impurity is introduced, are formed.

Next, a P type impurity, such as boron, having a concentration of 1 x 10¹⁴cm⁻² to 1 x 10¹⁶cm⁻² is introduced into the silicon film 102 using the formed resist pattern 105 as a mask. Then, an anneal is performed so as to form polycrystalline silicon regions 106 and 107 into each of which a P type impurity is introduced.

Subsequently, as shown in FIG. 1E, the silicon film 102 is processed by the photolithography technology and an etching technology so as to form gate electrodes 108a to 108c. Then, source/drain regions 152 and 153 are formed by using a method such as an impurity implantation. Furthermore, a wiring (not shown) is also formed in this step.

As shown in FIG. 1E, an N type MOS transistor 109a, having the gate electrode into which an N type impurity is introduced, and an N type MOS transistor 109b, having a P type polycrystalline silicon film as the gate electrode are both formed in an interior of the P type well 150. The N type MOS transistor 109a, having the gate electrode into which an N type impurity is introduced, and the N type MOS transistor 109b, having a P type polycrystalline silicon film as the gate electrode are included in the pixel 5. Particularly, the amplifying transistor 55 is preferably the N type MOS transistor having the gate electrode into which the P type impurity is introduced. The reasons, for which the N type MOS transistor, having the gate electrode into which the P type impurity is introduced, functions as a buried channel type MOS transistor, will be described later.

A P type MOS transistor 109c formed on the N type well 151 has a P type polycrystalline silicon film as the gate electrode. Thus, the P type MOS transistor 109c acts as a surface channel type MOS transistor.

As such, the solid-state imaging device according to the first embodiment is fabricated based on the fabrication steps mentioned above. Hereinafter, the reasons, for which the N type MOS transistor, having the P type polycrystalline silicon film as the gate electrode, functions as the buried type MOS transistor, will be described.

In the N type MOS transistor having the gate electrode into which the P type impurity is introduced, an electric potential is increased in a vicinity of an interface between the insulating film 101 and the P type well 150, due to the difference between a work function of the insulating film 101 and a work function of the P type well 150, thereby causing carrier electron to be pushed into the interior of the substrate. Therefore, the MOS transistor 109b functions as a buried channel type MOS transistor.

Since the amplifying transistor 55 directly amplifies a pixel signal obtained by a photoelectric conversion, a flicker noise generated by the amplifying transistor 55 is accordingly amplified. Therefore, when the amplifying transistor 55 is the buried type MOS transistor, the flicker noise generated by the amplifying transistor 55 can be reduced. As a result, a noise superimposed on the pixel signal outputted from the output amplifier 4 can be substantially reduced, thereby making it possible to provide a high-performance solid-state imaging device capable of reducing a noise generated.

Generally, in a buried channel type MOS transistor, a distance between a gate electrode and a channel is long, as compared to a surface channel type MOS transistor, thereby generating a time difference between a change in gate voltage and a change in an electric potential of a channel region. Therefore, when the buried channel type MOS transistor is used, a driving speed of the solid-state imaging device cannot be improved. However, since each of the transistors included in the pixel 5 (e.g., the amplifying transistor 55) performs an ON/OFF operation once each time a pixel signal is read, a high driving speed is not required. Thus, no problem on the driving speed will occur.

On the other hand, since each of the transistors used in a logic circuit in a vicinity of the pixel 5 (e. g. , the transistors used in the signal processing region 3) must perform an ON/OFF operation a plurality of times each time a pixel signal is read, a high driving speed is required. Therefore, the each of the transistors used in the logic circuit in the vicinity of the pixel 5 is preferably a surface channel type MOS transistor.

According to the method for fabricating the solid-state imaging device according to the first embodiment, it is possible to use a buried channel type MOS transistor as a transistor, included in the pixel 5, which does not require a high driving speed, and to use surface channel type MOS transistors as transistors, used in a logic circuit in the vicinity of the pixel 5, which require a high driving speed. As a result, a solid-state imaging device, capable of both reducing a noise and maintaining a high driving speed, can be provided.

Furthermore, the conventional MOS type solid-state imaging device is dual gate type (i.e., such a solid-state imaging device comprises an N type MOS transistor having an N type gate electrode and a P type MOS transistor having a P type gate electrode) . In a method for fabricating the conventional solid-state imaging device of the dual gate type, the introduction of an N type impurity or a P type impurity into a gate electrode of a surface channel type MOS transistor, and the introduction of an N type impurity or a P type impurity into a gate electrode of a buried channel type MOS transistor are performed in separate steps.

On the other hand, according to the method for fabricating the solid-state imaging device of the present embodiment, as shown in FIG. 1D, the introduction of a P type impurity into the gate electrode of the buried channel type MOS transistor of N type 109b, and the introduction of the P type impurity into the gate electrode of the surface channel type MOS transistor of P type 109c are simultaneously performed in the same step. In addition, the P type impurity and the N type impurity can be introduced in a separate manner only by changing a photomask.

Still furthermore, according to the method for fabricating the solid-state imaging device of the first embodiment, a buried channel type MOS transistor and a gate electrode into which a P type impurity is introduced can be formed by using the same photomask. Furthermore, the aforementioned photomask can be also used for introducing an implantation layer for adjusting a threshold voltage of the buried channel type MOS transistor.

Therefore, according to the method for fabricating the solid-state imaging device of the first embodiment, as compared to the method for fabricating the conventional solid-state imaging device, the solid-state imaging device of the present invention can be provided by a simple method without increasing the number of fabrication steps and the number of types of photomasks to be used.

### (first variant)

In the first embodiment, the amplifying transistor 55 is only a buried channel type MOS transistor. Alternatively, in a first variant of the first embodiment, each of transistors other than the amplifying transistor 55 may also be the buried channel type MOS transistor. Hereinafter, the first variant of the first embodiment will be described.

In the first variant, an N type MOS transistor using, as a gate electrode, a polycrystalline silicon into which a P type impurity is introduced (i.e., a buried channel type MOS transistor) is used as each of the amplifying transistor 55, the signal input transistor 71, the column selection transistor 73, and the output amplifier 4, all of which directly process pixel signals.

Also, in the first variant, an N type MOS transistor using, as a gate electrode, a polycrystalline silicon film into which an N type impurity is introduced (i.e., a surface channel type MOS transistor) is used as each of the transmission transistor 52, the reset transistor 56, and the signal retention transistor 72, all of which do not directly process the pixel signals.

As described above, according to the first variant, the buried channel type MOS transistors are used as not only the amplifying transistor 55 but also the signal input transistor 71, the column selection transistor 73 and the output amplifier 4, all of which directly process the pixel signals, and the surface channel type MOS transistors are used as the transistors other than the four elements mentioned above.

According to a method for fabricating the solid-state imaging device according to the first variant, as compared to the solid-state imaging device according to the first embodiment, the number of the buried channel type MOS transistors included in the solid-state imaging device is increased, thereby causing a driving speed of the solid-state imaging device to be reduced.

However, the surface channel type MOS transistors are also used as the transistors which do not directly process signals, and the buried channel type MOS transistors are only used as the transistors which directly process the signals, thereby making it possible to minimize the reduction of the driving speed of the solid-state imaging device.

As described above, in the case where a flicker noise is generated by the transistors which directly process the signals, a noise superimposed on a pixel signal outputted from the output amplifier 4 is increased. Therefore, in the first variant, the buried channel type MOS transistors are only used as the transistors which directly process the signals, in order to reduce the noise superimposed on the pixel signal outputted from the output amplifier 4.

On the other hand, a flicker noise generated by the transistors which do not directly process the signals does not affect a pixel signal outputted from the output amplifier 4. Therefore, in the first variant, the surface channel type MOS transistors are only used as the transistors which do not directly process the signals, in order to prevent the driving speed of the solid-state imaging device from being reduced.

In the first variant, it is possible to provide a high-performance solid-state imaging device capable of reducing a flicker noise more than the solid-state imaging device fabricated by the fabrication method according to the first embodiment.

It is understand that the fabrication method described in the first embodiment above can be also used for fabricating the solid-state imaging device according to the first variant.

### (second variant)

Still alternatively, in a second variant of the first embodiment, each of the transistors shown in FIG. 3 may be an N type MOS transistor using, as a gate electrode, a polycrystalline silicon into which a P type impurity is introduced (i.e., a buried channel type MOS transistor).

According to the second variant, in the fabrication method described in the first embodiment, the N type MOS transistor having a P type polycrystalline silicon film as the gate electrode (i.e., the buried channel type MOS transistor) is used as each of the transistors formed in the N type well 151.

Also, according to the second variant, an N type MOS transistor having an N type polycrystalline silicon film as a gate electrode or a P type MOS transistor having a P type polycrystalline silicon film as a gate electrode (i.e., a surface channel type MOS transistor) is used as each of transistors, other than the transistors formed in the N type well 151, which are included in the solid-state imaging device.

According to the second variant, the each of the transistors shown in FIG. 3 is the buried channel type MOS transistor, thereby making it possible to reduce a flicker noise generated as much as possible. In the case where a desired driving speed of the solid-state imaging device is not specified, the buried channel type MOS transistor is used as each of the transistors shown in FIG. 3, thereby making it possible to fabricate a solid-state imaging device having an image quality higher than that of the solid-state imaging device according to the first variant.

It is understood that the fabrication method described in the first embodiment above can be also used for fabricating the solid-state imaging device according to the second variant.

Although the above description illustrates an example where the MOS transistors 109a, 109b and 109c are disposed as shown in FIG. 1E, the present invention is not limited thereto. The MOS transistors 109a, 109b and 109c may be disposed in a manner different from that shown in FIG. 1E.

While the invention has been described in detail, the foregoing description is in all aspects illustrative and not restrictive. It is understood that numerous other modifications and variations can be devised without departing from the scope of the invention.

## Claims

1. A solid-state imaging device comprising a pixel region (2) in which a plurality of pixels (5) are disposed in a form of a matrix on a semiconductor substrate, wherein
each of the plurality of pixels (5) includes:
a photodiode (51) for photoelectrically converting an incident light; and
an amplifying transistor (55) for amplifying a pixel signal outputted from the photodiode (51), and the amplifying transistor (55) is a buried channel type MOS transistor.

2. The solid-state imaging device according to claim 1, wherein
each of the plurality of pixels (5) further includes:
a transmission transistor (52); and
a reset transistor (56), and
each of the transmission transistor (52) and the reset transistor (56) is a surface channel type MOS transistor.

3. The solid-state imaging device according to claim 1, further comprising a noise canceling circuit (7), disposed on the semiconductor substrate and at an exterior of the pixel region (2), for removing a noise component included in the pixel signal outputted from the amplifying transistor (55) and,
an output amplifier (4), disposed on the semiconductor substrate and at the exterior of the pixel region (2), for amplifying the pixel signal outputted from the noise canceling circuit (7), and outputting the amplified pixel signal, wherein
each of transistors forming the noise canceling circuit (7) and a transistor as the output amplifier (4) is a surface channel type MOS transistor.

4. The solid-state imaging device according to claim 2, further comprising a noise canceling circuit (7), disposed on the semiconductor substrate and at an exterior of the pixel region (2), for removing a noise component included in the pixel signal outputted from the amplifying transistor (55) and,
an output amplifier (4), disposed on the semiconductor substrate and at the exterior of the pixel region (2), for amplifying the pixel signal outputted from the noise canceling circuit (7), and outputting the amplified pixel signal, wherein
each of transistors forming the noise canceling circuit (7) and a transistor as the output amplifier (4) is the surface channel type MOS transistor.

5. The solid-state imaging device according to claim 1, further comprising a noise canceling circuit (7), disposed on the semiconductor substrate and at an exterior of the pixel region (2), for removing a noise component included in the pixel signal outputted from the amplifying transistor (55) and,
an output amplifier (4), disposed on the semiconductor substrate and at the exterior of the pixel region (2), for amplifying the pixel signal outputted from the noise canceling circuit (7), and outputting the amplified pixel signal, wherein at least one of transistors forming the noise canceling circuit (7) or a transistor as the output amplifier (4) is the buried channel type MOS transistor.

6. The solid-state imaging device according to claim 2, further comprising a noise canceling circuit (7), disposed on the semiconductor substrate and at an exterior of the pixel region (2), for removing a noise component included in the pixel signal outputted from the amplifying transistor (55) and,
an output amplifier (4), disposed on the semiconductor substrate and at the exterior of the pixel region (2), for amplifying the pixel signal outputted from the noise canceling circuit (7), and outputting the amplified pixel signal, wherein at least one of transistors forming the noise canceling circuit (7) or a transistor as the output amplifier (4) is a buried channel type MOS transistor.

7. The solid-state imaging device according to claim 1, further comprising a noise canceling circuit (7), disposed on the semiconductor substrate and at an exterior of the pixel region (2), for removing a noise component included in the pixel signal outputted from the amplifying transistor (55) and,
an output amplifier (4), disposed on the semiconductor substrate and at the exterior of the pixel region (2), for amplifying the pixel signal outputted from the noise canceling circuit (7), and outputting the amplified pixel signal, wherein each of N type MOS transistors included in the pixel region (2), the noise canceling circuit (7) and the output amplifier (4) is the buried channel type MOS transistor.

8. The solid-state imaging device according to claim 1, wherein
the amplifying transistor (55) is an N type MOS transistor having a P type silicon film as a gate electrode.

9. The solid-state imaging device according to claim 2, wherein
the amplifying transistor (55) is an N type MOS transistor having a P type silicon film as a gate electrode.

10. The solid-state imaging device according to claim 3, wherein
the amplifying transistor (55) is an N type MOS transistor having a P type silicon film as a gate electrode.

11. The solid-state imaging device according to claim 4, wherein
the amplifying transistor (55) is an N type MOS transistor having a P type silicon film as a gate electrode.

12. The solid-state imaging device according to claim 5, wherein
the amplifying transistor (55) is an N type MOS transistor having a P type silicon film as a gate electrode.

13. The solid-state imaging device according to claim 6, wherein
the amplifying transistor (55) is an N type MOS transistor having a P type silicon film as a gate electrode.

14. The solid-state imaging device according to claim 7, wherein
the amplifying transistor (55) is an N type MOS transistor having a P type silicon film as a gate electrode.

15. The solid-state imaging device according to claim 2, wherein
each of the transmission transistor (52) and the reset transistor (56) is an N type MOS transistor having an N type silicon film as a gate electrode.

16. The solid-state imaging device according to claim 3, wherein
each of the transmission transistor (52) and the reset transistor (56) is an N type MOS transistor having an N type silicon film as a gate electrode.

17. A method for fabricating a solid-state imaging device comprising a P type MOS transistor and N type MOS transistors of a plurality of types on a semiconductor substrate, the method comprising:
a film forming step of forming a film (102), on the semiconductor substrate, which is made from a material used for forming a gate electrode;
a resist pattern forming step of forming a photo resist pattern (105) on a surface of the formed film (102), the photo resist pattern having openings in regions where the P type MOS transistor and the N type MOS transistors of at least one of the plurality of types are formed; and
an impurity implanting step of introducing a P type impurity into the film (102) using the formed photo resist pattern (105) as a mask.
